# EUROPÄISCHE PATENTSCHRIFT

(11) **EP 1 263 269 B1**
(45) Veröffentlichungstag und Bekanntmachung des Hinweises auf die Patenterteilung: **28.07.2004**
(21) Anmeldenummer: 02010634.0
(22) Anmeldetag: 11.05.2002
(51) Int. Cl.: H05K 1/02

(54) **Folienleiter, wie Folienleiterkabel oder -platte**
Foil conductor, such as foil conductor cable or foil circuit board
Feuille à conducteurs, comme câble à conducteurs en feuille ou panneau à circuit en feuille

(30) Priorität: 21.05.2001 DE 20108532 U
(43) Veröffentlichungstag der Anmeldung: 04.12.2002
(73) Patentinhaber: Coroplast Fritz Müller GmbH & Co. KG, 42279 Wuppertal (DE)
(72) Erfinder: Blaschke, Jörg, 42369 Wuppertal (DE)
(74) Vertreter: Patentanwälte Dr. Solf & Zapf

(56) Entgegenhaltungen:
- EP-A- 0 827 372
- DE-A- 19 819 057
- DE-U- 20 013 651
- DE-U- 29 922 805
- FR-A- 2 714 250
- PATENT ABSTRACTS OF JAPAN vol. 1999, no. 12, 29. Oktober 1999 (1999-10-29) & JP 11 204964 A (YAZAKI CORP), 30. Juli 1999 (1999-07-30)
- PATENT ABSTRACTS OF JAPAN vol. 2000, no. 06, 22. September 2000 (2000-09-22) & JP 2000 077148 A (FURUKAWA ELECTRIC CO LTD:THE), 14. März 2000 (2000-03-14)

## Beschreibung

Die vorliegende Erfindung betrifft einen Folienleiter, wie ein Folienleiterkabel oder eine Folienleiterplatte, mit mindestens einer Trägerfolie, auf der elektrische. Leiterzüge angeordnet sind, welche durch mindestens eine mit der Trägerfolie und den Leiterzügen verbundene Deckschicht abgedeckt sind, wodurch mindestens eine flexible gedruckte Schaltung aufgebaut ist.

Bei gedruckten Leiterplatten werden in allgemeiner Form zwei Gruppen unterschieden: eine Gruppe mit steifem und eine Gruppe mit flexiblem Träger, wobei die Leiterplatten der zweiten Gruppe auch als Folienleiterplatten bezeichnet werden können. Solche Folienleiterplatten, die bei einer einfachen Herstellungsweise ein ausgezeichnetes Biegevermögen aufweisen, werden bevorzugt dort eingesetzt, wo sich elektrische Schaltungen problemlos der Geometrie des Einsatzortes anpassen müssen oder einer wiederholten Biegebeanspruchung unterworfen sind (beispielsweise in der Automobilindustrie oder in der Computertechnik). Sie weisen ein geringes Gewicht auf und können, da sie sehr flach sind, platzsparend in die verschiedensten Systeme integriert werden.

Bei Folienleitern, die zur Herstellung sogenannter FPC's (Flexible Printed Circuits) oder auch nur zur Herstellung äußerst flacher Kabel, sogenannter FFC's (Flexible Printed Cables) verwendet werden, basiert das Material der Trägerfolie dabei zumeist auf Polyimid- oder Polyesterverbindungen, während die Leiterzüge aus elektrolytisch abgeschiedener oder gewalzter Kupferfolie bestehen. Für die Deckschicht kann entweder - wie für den Träger - ebenfalls eine Folie oder auch ein flexibler Lack zur Anwendung kommen. Trägerfolie, Leiterzüge und Deckschicht können mit Klebstoff und/oder unter Anwendung von Wärme und Druck miteinander verbunden werden.

Im Automobilbau finden FPC's Verwendung, die mindestens einen Leiterplattenbereich, in der Regel mehrere Leiterplattenbereiche, aufweisen, die jeweils als Anschlußleitung (FPC oder FFC) ausgebildet sind, an deren freien Ende sich ein Stecker befindet. Die Anschlußleitungen sind von den übrigen, insbesondere für eine Befestigung an einem Bauteil, wie einer Kraftfahrzeugkarosserie, vorgesehenen Leiterplattenbereichen separiert. Die Montage dieser bekannten FPC's ist im Vergleich mit der Montage von einfach oder gebündelt verlegten Kabeln bzw. Kabelsätzen vereinfacht: Die für die Befestigung vorgesehenen Leiterplattenbereiche werden an dem Bauteil befestigt, insbesondere mit diesem verklebt und dann die Anschlußleitungen elektrisch - insbesondere über Steckverbindungen - kontaktiert.

In der deutschen Patentanmeldung 100 31 940.8 ist ein als Folienleiterplatte ausgebildeter Folienleiter der eingangs beschriebenen Art vorgeschlagen worden. Bei dieser Folienleiterplatte (FPC) ist ein als Anschlußleitung (FPC oder FFC) ausgebildeter Leiterplattenbereich über mindestens eine in dem Verbund von Trägerfolie und Deckschicht angeordnete Schwächungslinie mit einem oder mehreren anderen Leiterplattenbereichen verbunden. Dadurch weist die Folienleiterplatte bei vereinfachter Montagemöglichkeit eine verbesserte Handhabbarkeit auf. Ein Folienleiter dieser Art hat sich in der Praxis bewährt, da bei Verpackung, Versand und Transport, sowie beim Montagevorgang die als Anschlußleitungen ausgebildeten Leiterplattenbereiche, die einbaubedingt auch teilweise in größerer Länge ausgeführt sein können, sich nicht ineinander verhaken sowie leicht verlegt und befestigt werden können.

Ein Folienleiter gemäß dem Oberbegriff des Anspruchs 1 wird un der DE-A-198 19 057 gezeigt.

Der vorliegenden Erfindung liegt die Aufgabe zugrunde, einen Folienleiter der eingangs genannten Art unter dem Gesichtspunkt der Erhöhung seiner Montagefreundlichkeit und der erzielbaren Montagesicherheit noch weiter zu verbessern.

Diese Aufgabe wird mit einem Folienleiter der eingangs genannten Art gelöst, bei dem auf der Unterseite der Trägerfolie oder auf der Oberseite der Deckschicht ein Scharnierteil befestigt ist, das eine definierte Knicklinie festlegt, wobei die Knicklinie durch eine nutartige Ausnehmung in dem Scharnierteil festgelegt und wobei das Scharnierteil als Filmscharnier ausgebildet ist, zusammen mit den kennzeichnenden merkmalen des Anspruchs 1.

Das erfindungsgemäß vorgesehene Scharnierteil kann vorteilhafterweise als ein Folienhalter wirken und dient der optimalen Verlegung einer Folienschaltung, beispielsweise als eine Verlege-Hilfe für ein Folienleiterkabel oder eine Folienleiterplatte im Dachhimmel eines Kraftfahrzeugs. Die Knickstellen sind durch das Scharnierteil direkt zu erkennen und ermöglichen bei der Montage ein schnelles Verlegen des Folienleiters. Zusätzliche Markierungspunkte auf dem Bauteil, auf dem der Folienleiter verlegt werden soll, können entfallen. Für den Folienleiter selbst können somit mit Vorteil unter Vermeidung von Bruchstellen definierte Knickradien und Knicklagen eingestellt werden.

Das Scharnierteil kann insbesondere in einem als Anschlußleitung ausgebildeten Bereich eines Folienleiters angeordnet sein. Es kann dabei mit der Trägerfolie oder mit der Deckschicht in einfacher Weise z.B. über eine Klebeverbindung oder durch Ultraschallschweißen sowie auch durch mechanische Rastzonen oder andere mechanische Haltesysteme verbunden werden. Ein Ultraschallverschweißen ist insbesondere dann möglich, wenn das Scharnierteil aus Kunststoff, insbesondere aus einer Kunststoff-Folie, besteht. Bei der Herstellung des erfindungsgemäßen Folienleiters ist so vorteilhafterweise ein hoher Automatisierungsgrad beim Bestücken von Folienleiterkabeln oder Folienleiterplatten mit Scharnierteilen zu erreichen.

Erfindungsgemäß ist das Scharnierteil dabei als Filmscharnier ausgebildet. Mit einem solchen Filmscharnier sind sehr kleine Bauformen, insbesondere eine sehr flache Bauhöhe, z.B. Dicken von etwa 1 bis 2 mm, und genaue Knickwinkel, z.B. 45°, 60° oder 90°, erzielbar.

Weitere vorteilhafte Ausführungen der Erfindung sind in den Unteransprüchen und der nachfolgenden speziellen Beschreibung enthalten.

Anhand eines in der beiliegenden Zeichnung dargestellten Ausführungsbeispiels wird die Erfindung näher erläutert. Dabei zeigen:
- Fig. 1: den prinzipiellen Aufbau eines Folienleiters,
- Fig. 2: als exemplarischen Anwendungsfall eines erfindungsgemäßen Folienleiters eine Unteransicht eines Kraftfahrzeug-Dachhimmels, auf dem eine Folienleiterplatte (FPC) mit Anschlußkabeln (FPC oder FFC) verlegt ist,
- Fig. 3: eine Ausführungsform eines bei einem erfindungsgemäßen Folienleiter zum Einsatz kommenden Scharnierteils in der Draufsicht,
- Fig. 4: das in Fig. 3 dargestellte Scharnierteil in Längsschnitt,
- Fig. 5 und 6: in Fig. 4 entsprechenden Darstellungen, das Scharnierteil, jedoch in unterschiedlich geklappten Winkeln.

In den verschiedenen Figuren der Zeichnung sind gleiche Teile stets mit denselben Bezugszeichen versehen und werden daher in der Regel auch jeweils nur einmal beschrieben.

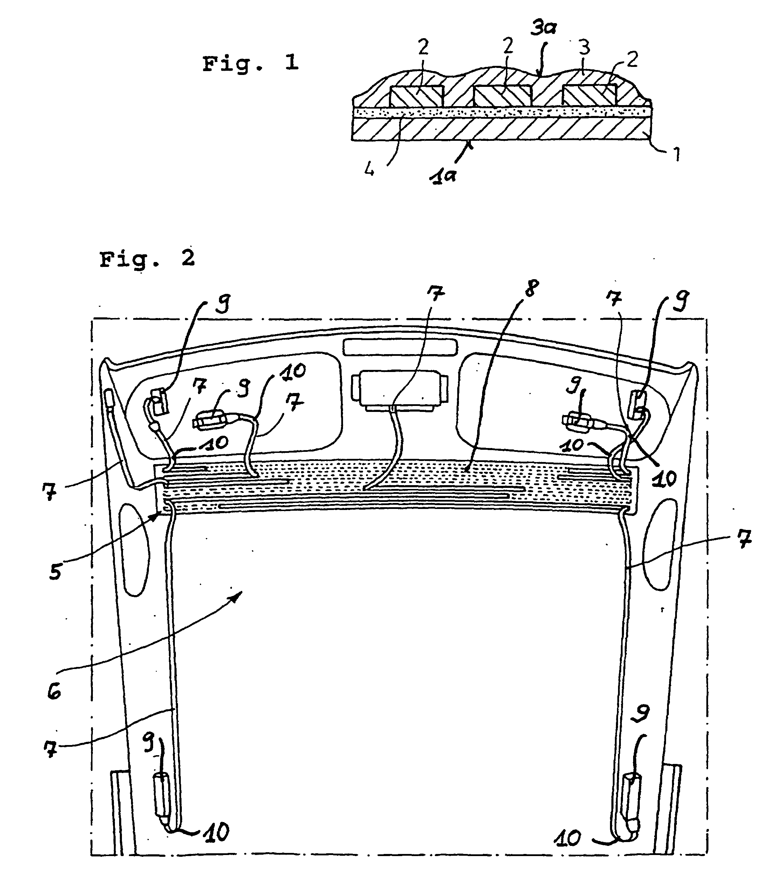

Wie zunächst aus Fig. 1 hervorgeht, weist ein erfindungsgemäßer Folienleiter eine Trägerfolie 1 auf, auf der elektrische Leiterzüge 2 angeordnet sind, welche durch eine Deckschicht 3 abgedeckt sind. Dadurch ist eine flexible gedruckte Schaltung in Form einer Leiterplatte (FPC) oder eines Kabels (FFC) gebildet. Die Deckschicht 3 kann dabei aus einer Deckfolie oder auch aus einem Decklack bestehen. Die Trägerfolie 1, die Leiterzüge 2 und die Deckschicht 3 können vorzugsweise - wie dargestellt - über Klebeverbindungen 4 miteinander verbunden sein. Ein solcher Folienleiteraufbau ist an sich bekannt.

Ein Montagebeispiel für einen erfindungsgemäßen Folienleiter wird durch Fig. 2 veranschaulicht. Dabei ist eine Folienleiterplatte 5 (FPC) an einem Bauteil 6 - bei der dargestellten Ausführung an einem Formhimmel eines Automobils - befestigt. Dabei führen jeweils als Anschlußleitungen 7 (FPC oder FFC) ausgebildete Bereiche des Folienleiters zu verschiedenen elektrischen Anschlußstellen am Bauteil 6. Die erfindungsgemäße Folienleiterplatte 5 kann mit dem Bauteil 6 zur Befestigung insbesondere verklebt werden.

Dazu kann vorzugsweise ein doppelseitiges Hybridklebeband eingesetzt werden, wobei dieses zuerst mit einer Klebeseite auf das Bauteil 6 geklebt wird und wobei danach die Verklebung der Folienleiterplatte 5 mit der anderen Klebeseite erfolgt. Alternativ könnte zu diesem Zweck auch auf der Unterseite 1a der Trägerfolie 1 oder auf der Oberseite 3a der Deckschicht 3 ein Klettband zur Montage an dem Bauteil 6 befestigt sein.

Die als elektrische Anschlußleitungen 7 ausgebildeten Folienleiterbereiche waren vor ihrer Montage - wie aus der zeichnerischen Darstellung unschwer zu entnehmen ist - jeweils über in der Trägerfolie 1 und in der Deckschicht 3 angeordnete Schwächungslinien 8 mit anderen Folienleiterbereichen verbunden. Bei den Schwächungslinien 8 kann es sich dabei mit Vorteil um Perforationslinien handeln, die einfach durch Stanzen in eine Folienleiterplatte eingebracht werden können. Alternativ wäre es aber beispielsweise auch mit Vorteil möglich, die Schwächungslinien 8 durch Ritzen des Verbundes aus Trägerfolie 1 und Deckschicht 3 (Ritzen von Trägerfolie 1 und/oder Deckschicht 3) zu erzeugen.

Die jeweils als Anschlußleitungen 7 ausgebildeten Folienleiterbereiche können bei der Herstellung des Folienleiters in einem Endabschnitt, der etwa der Größe eines Steckerteiles entspricht, aus der Folienleiterplatte 5 herausgetrennt und, insbesondere mittels eines Crimpautomaten, jeweils mit einem Steckerteil 9 konfektioniert werden, das dann bei der Montage in einfacher Weise zur Kontaktierung einer Anschlußstelle eingesetzt werden kann.

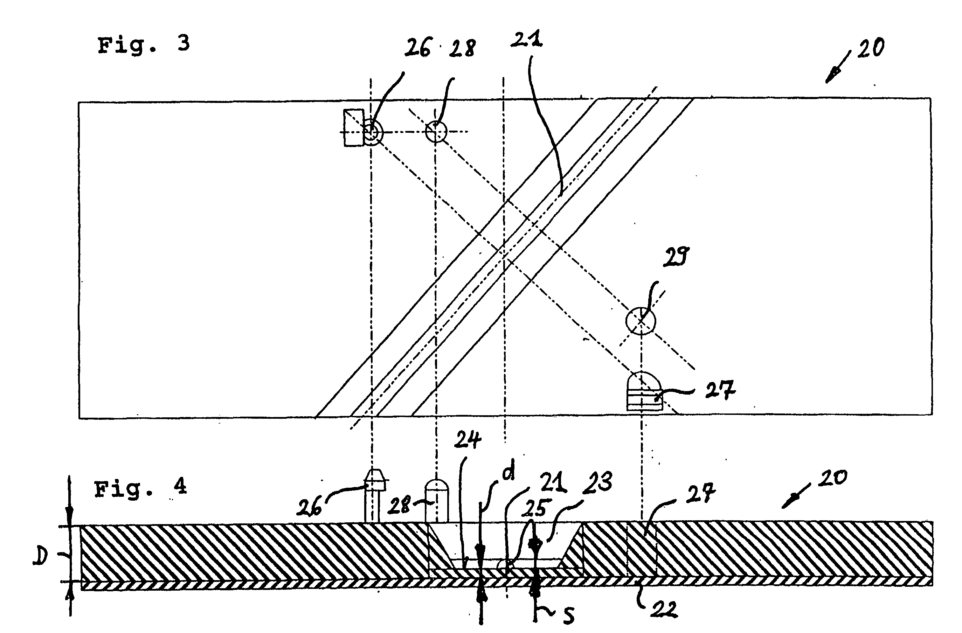

Bei der Montage werden im vorliegenden Ausführungsbeispiel die als Anschlußleitungen 7 ausgebildeten Folienleiterbereiche derart verlegt, daß sich verschiedene Knickstellen 10 bilden. Für die optimale Ausbildung dieser Knickstellen 10 ist es erfindungsgemäß vorgesehen, daß (bevorzugt) auf der Unterseite 1a der Trägerfolie 1 oder auf der Oberseite 3a der Deckschicht 3 ein Scharnierteil 20 befestigt ist, das jeweils in Fig. 3 bis 6 als Einzelteil dargestellt ist und das eine definierte Knicklinie 21 festlegt.

Das Scharnierteil 20 kann mit der Trägerfolie 1 oder mit der Deckschicht 3 insbesondere über eine Klebeverbindung verbunden sein, wobei wiederum insbesondere ein doppelseitiges Hybridklebeband - wie oben beschrieben - Verwendung finden kann. (Ein solches Klebeband ist in Fig. 4 bis 6 mit dem Bezugszeichen 22 bezeichnet.) Alternativ könnte das Scharnierteil 20 mit der Trägerfolie 1 oder mit der Deckschicht 3 auch ultraschallverschweißt bzw. - wie bereits erwähnt - durch mechanische Rastzonen oder andere mechanische Haltesysteme verbunden werden

Das Scharnierteil 20 kann bevorzugt aus Kunststoff, insbesondere aus einer Kunststoff-Folie, bestehen und - wie dargestellt - als Filmscharnier ausgebildet sein. Es kann dabei vorteilhafterweise eine Gesamtdicke D (Fig. 4) im Bereich von etwa 0,5 bis 3,0 mm, insbesondere im Bereich von etwa 1,0 bis 2,0 mm aufweisen. Dadurch wird eine vorteilhaft sehr flache Bauform und ein optimales Verhältnis von Flexibilität und Stabilität erzielt.

Die Knicklinie 21 kann in dem Scharnierteil 20 insbesondere durch eine nutartige Ausnehmung 23 festgelegt sein, die z.B. - wie in Fig. 4 gezeigt - einen trapezförmigen Querschnitt aufweist, wenn das Scharnierteil sich in gestreckter Lage befindet. Im Bereich der nutartigen Ausnehmung 23 kann die Dicke d des Scharnierteils 20 insbesondere etwa 0,1 bis 0,3 mm betragen.

Zur Erzielung eines optimalen Biegeverhaltens und der genauen Fixierung der Knicklinie 21 kann auf einem Boden 24 der nutartigen Ausnehmung 23 längs der Knicklinie 21 ein Verstärkungsgrat 25, insbesondere mit einer Dicke s von etwa 0,2 bis 0,6 mm, verlaufen.

Des weiteren kann mindestens auf einer Seite der Knicklinie 21 am Scharnierteil 20 ein Verschlußelement, angeordnet sein, insbesondere kann alternativ zu der nachfolgend dargestellten Ausführung auf der Oberfläche des Scharnierteils 20 ein doppeltklebender Klebebandabschnitt befestigt sein (nicht dargestellt).

In bevorzugter Ausführung können - wie aus Fig. 3 bis 5 ersichtlich - beidseitig und symmetrisch zur Knicklinie 21 am Scharnierteil 20 Verschlußelemente 26, 27 angeordnet, insbesondere einander korrespondierende Rastelemente befestigt sein. Diese Rastelemente können - wie dargestellt - z.B. aus mindestens einem Rasthaken 26 und aus einem korrespondierenden Rastfenster 27 gebildet sein. Dadurch kann im Einbauzustand eine definierte Knicklage des Folienleiters - auch unter dynamischer Beanspruchung, beispielsweise in einem Kraftfahrzeug - dauerhaft bewahrt werden.

Zusätzlich können - wie ebenfalls aus Fig. 3 bis 5 ersichtlich - beidseitig und symmetrisch zur Knicklinie 21 am Scharnierteil 20 formschlüssig ineinandergreifende Fixierelemente 28, 29 angeordnet sein. Diese Fixierelemente 28, 29 können - wie dargestellt - z.B. aus mindestens einem stiftartigen Fixierfinger 28 und aus einem korrespondierenden Fixierfenster 29 gebildet sein. Durch die Fixierelemente 28, 29 wird vorteilhafterweise eine Minderung der Beanspruchung der Verschlußelemente 26, 27, insbesondere eine Spannungsentlastung und Verhinderung einer Abschergefahr des Rasthakens 26, sowie eine Sicherung gegen laterale Verschiebungen der beidseitig der Knicklinie 21 liegenden Folienleiterabschnitte gegeneinander erreicht.

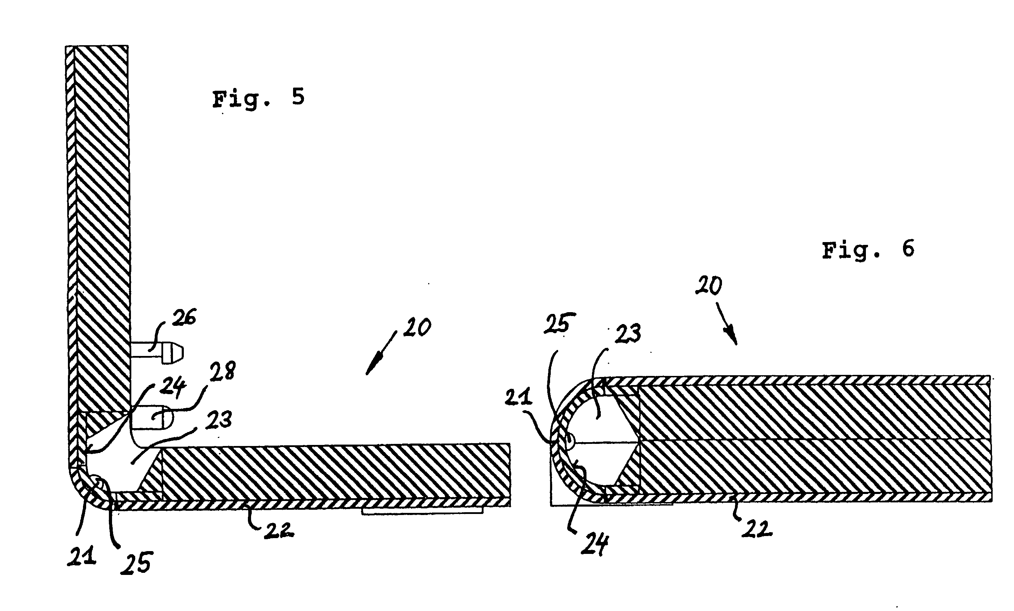

Bei dem erfindungsgemäßen Folienleiter ist, wie bereits erwähnt, die genaue Einhaltung unterschiedlicher Knickwinkel möglich. Auch definierte Knickradien der FPC/FFC (Folienleiterplatte 5 / Anschlußleitung 7) können dabei unter Vermeidung von Bruchstellen eingehalten werden. So zeigt Fig. 5 eine Knicklage, in der die beidseitig der Knicklinie 21 liegenden Folienleiterabschnitte einen Winkel von 90° einschließen, und Fig. 6 eine Knicklage, in der die beidseitig der Knicklinie 21 liegenden Folienleiterabschnitte einen Winkel von 180° einschließen, d.h. vollständig aufeinander geklappt sind.

Die Erfindung beschränkt sich nicht auf das beschriebene Ausführungsbeispiel. Bei dem Folienleiter kann es sich - wie dargestellt - um ein Kabel (FFC / Anschlußleitung 7) oder um eine ganze Platte (FPC / Folienleiterplatte 5) handeln. Im Folienleiter können sich ein oder mehrere Schaltungen befinden. Die unterschiedlich mögliche Ausführung der Verschlußelemente 26, 27 wurde ebenfalls bereits erwähnt. Je nach der Länge der Knicklinie 21 können bedarfsweise auch mehr Verschlußelemente 26, 27 zum Einsatz kommen als dargestellt. Gleiches trifft auch auf die Fixierelemente 28, 29 zu.

Des weiteren fällt es beispielsweise auch in den Rahmen der Erfindung, wenn, wie in der deutschen Gebrauchsmusteranmeldung 299 16 367.9 vorgeschlagen wurde, in einem Endabschnitt des als Anschlußleitung ausgebildeten Leiterplattenbereiches nach dem Aufbringen der Deckschicht 3 aus der Schaltung selbst, insbesondere durch Faltung, ein Steckerteil 9 gebildet wird.

Schließlich sind durch die Erfindung auch flexible Multilagenplatten (sog. Built-up-Platten) mit mehreren übereinanderliegenden Leiterzügen 2 umfaßt, die durch mehrere übereinanderliegende, nach der Art einer Trägerfolie 1 oder einer Deckschicht 3 ausgebildete Zwischenschichten voneinander getrennt sind, wie sie in den letzten Jahren weite Verbreitung gefunden haben.

### Bezugszeichen

- 1: Trägerfolie
- 1a: Unterseite von 1
- 2: Leiterzug
- 3: Deckschicht
- 3a: Oberseite von 3
- 4: Klebeverbindung (zwischen 1 und 2 bzw. 2 und 3)
- 5: Folienleiterplatte (FPC)
- 6: Bauteil (Kfz-Dachhimmel)
- 7: Anschlußleitung, Folienleiterkabel (FFC oder FPC)
- 8: Schwächungslinien
- 9: Steckerteil
- 10: Knickstelle
- 20: Scharnierteil
- 21: Knicklinie
- 22: Klebeband
- 23: Ausnehmung in 20
- 24: Boden von 23
- 25: Verstärkungsgrat
- 26: Verschlußelement (Rasthaken)
- 27: Verschlußelement (Rastfenster)
- 28: Fixierelement (Fixierfinger)
- 29: Fixierelement (Fixierfenster)

- D: Gesamtdicke von 20
- d: Dicke von 20 im Bereich von 23
- s: Dicke von 25

## Patentansprüche

1. Folienleiter, wie Folienleiterkabel (7) oder -platte (5), mit mindestens einer Trägerfolie (1), auf der elektrische Leiterzüge (2) angeordnet sind, welche durch mindestens eine mit der Trägerfolie (1) und den Leiterzügen (2) verbundene Deckschicht (3) abgedeckt sind, wodurch mindestens eine flexible gedruckte Schaltung aufgebaut ist, wobei auf der Unterseite (1a) der Trägerfolie (1) oder auf der Oberseite (3a) der Deckschicht (3) ein Scharnierteil (20) befestigt ist, das eine definierte Knicklinie (21) festlegt, wobei die Knicklinie (21) durch eine nutartige Ausnehmung (23) in dem Schamierteil (20) festgelegt und wobei das Schamierteil (20) als Filmschamier ausgebildet ist,
**dadurch gekennzeichnet, daß** die nutartige Ausnehmung (23) einen trapezförmigen Querschnitt aufweist, wenn das Schamierteil (20) sich in gestreckter Lage befindet, wobei der Boden der Ausnehmung unterseitig an der Unterseite (1a) der Trägerfolie (1) oder auf der Oberseite (3a) der Deckschicht (3) befestigt ist, derart, daß unter Vermeidung von Bruchstellen definierte Knickradien und Knickwinkel, wie 45°, 60°, 90° oder 180°, einstellbar sind.

2. Folienleiter nach Anspruch 1,
**dadurch gekennzeichnet, daß** das Scharnierteil (20) in einem als Anschlußleitung (7) ausgebildeten Bereich einer Folienleiterplatte (5) angeordnet ist.

3. Folienleiter nach Anspruch 1 oder 2,
**dadurch gekennzeichnet, daß** das Scharnierteil (20) mit der Trägerfolie (1) oder mit der Deckschicht (3) über eine Klebeverbindung verbunden ist.

4. Folienleiter nach einem der Ansprüche 1 bis 3,
**dadurch gekennzeichnet, daß** das Scharnierteil (20) mit der Trägerfolie (1) oder mit der Deckschicht (3) über ein doppelseitiges Hybridklebeband (22) verbunden ist.

5. Folienleiter nach Anspruch 1 oder 2,
**dadurch gekennzeichnet, daß** das Scharnierteil (20) mit der Trägerfolie (1) oder mit der Deckschicht (3) ultraschallverschweißt oder durch ein mechanisches Haltesystem verbunden ist.

6. Folienleiter nach einem der Ansprüche 1 bis 5,
**dadurch gekennzeichnet, daß** das Scharnierteil (20) aus Kunststoff, insbesondere aus einer Kunststoff-Folie, besteht.

7. Folienleiter nach einem der Ansprüche 1 bis 6,
**dadurch gekennzeichnet, daß** das Scharnierteil (20) eine
Gesamtdicke (D) im Bereich von etwa 0,5 bis 3,0 mm, insbesondere im Bereich von etwa 1,0 bis 2,0 mm aufweist.

8. Folienleiter nach Anspruch 7,
**dadurch gekennzeichnet, daß** im Bereich der nutartigen Ausnehmung (23) eine Dicke (d) des Scharnierteils (20) etwa 0,1 bis 0,3 mm beträgt.

9. Folienleiter nach Anspruch 7 oder 8,
**dadurch gekennzeichnet, daß** auf einem Boden (24) der nutartigen Ausnehmung (23) längs der Knicklinie (21) ein Verstärkungsgrat (25), insbesondere mit einer Dicke (s) von etwa 0,2 bis 0,6 mm, verläuft.

10. Folienleiter nach einem der Ansprüche 1 bis 9,
**dadurch gekennzeichnet, daß** mindestens auf einer Seite der Knicklinie (21) am Scharnierteil (20) ein Verschlußelement, angeordnet ist, insbesondere auf der Oberfläche des Scharnierteils (20) ein doppeltklebender Klebebandabschnitt befestigt ist.

11. Folienleiter nach einem der Ansprüche 1 bis 10,
**dadurch gekennzeichnet, daß** beidseitig und symmetrisch zur Knicklinie (21) am Scharnierteil (20) Verschlußelemente (26, 27) angeordnet, insbesondere einander korrespondierende Rastelemente befestigt oder ausgebildet sind.

12. Folienleiter nach Anspruch 11,
**dadurch gekennzeichnet, daß** die Rastelemente aus mindestens einem Rasthaken (26) und aus einem korrespondierenden Rastfenster (27) gebildet sind.

13. Folienleiter nach einem der Ansprüche 1 bis 12,
**dadurch gekennzeichnet, daß** beidseitig und symmetrisch zur Knicklinie (21) am Scharnierteil (20) formschlüssig ineinandergreifende Fixierelemente (28, 29) angeordnet oder ausgebildet sind.

14. Folienleiter nach Anspruch 13,
**dadurch gekennzeichnet, daß** die Fixierelemente (28, 29) aus mindestens einem stiftartigen Fixierfinger (28) und aus einem korrespondierenden Fixierfenster (29) gebildet sind.

15. Folienleiter nach einem oder mehreren der Ansprüche 1 bis 14,
**dadurch gekennzeichnet, daß** jeweils als Anschlußleitungen (7) ausgebildete Bereiche der Folienleiterplatte (5) über mindestens eine in dem Verbund von Trägerfolie (1) und Deckschicht (3) angeordnete Schwächungslinie (8) mit einem oder mehreren anderen Bereichen verbunden sind.

16. Folienleiter nach Anspruch 15,
**dadurch gekennzeichnet, daß** die Schwächungslinie (8) eine Perforationslinie und/oder eine geritzte Linie ist

17. Folienleiter nach einem oder mehreren der Ansprüche 1 bis 16,
**dadurch gekennzeichnet, daß** an einem freien Ende eines als Anschlußleitung (7) ausgebildeten Bereiches ein Steckerteil (9) befestigt ist.

18. Folienleiter nach einem oder mehreren der Ansprüche 1 bis 17,
**dadurch gekennzeichnet, daß** auf der Unterseite (1a) der Trägerfolie (1) oder auf der Oberseite (3a) der Deckschicht (3) ein Klebeband oder ein Klettband zur Montage an einem Bauteil (6) befestigt ist.

## Claims

1. Foil conductor, such as a foil conductor cable (7) or foil circuit board (5), with at least one carrier foil (1), on which electrical conductor tracks (2) are arranged, which conductor tracks are covered by at least one covering layer (3) connected to the carrier foil (1) and to the conductor tracks (2), whereby at least one flexible printed circuit is created, a hinge part (20) which defines a fold line (21) being fastened on the underside (1a) of the carrier foil (1) or on the upper side (3a) of the covering layer (3), the fold line (21) being defined by a groove-like recess (23) in the hinge part (20) and the hinge part (20) being formed as a film hinge, **characterized in that** the groove-like recess (23) has a trapezoidal cross section when the hinge part (20) is in the stretched-out position, the bottom of the recess being fastened on the underside to the underside (1a) of the carrier foil (1) or on the upper side (3a) of the covering layer (3) in such a way that defined folding radii and folding angles, such as 45 degrees, 60 degrees, 90 degrees or 180 degrees, can be set while avoiding rupture points.

2. Foil conductor according to Claim 1, **characterized in that** the hinge part (20) is arranged in a region of a foil circuit board (5) that is formed as a connecting lead (7).

3. Foil conductor according to Claim 1 or 2, **characterized in that** the hinge part (20) is connected to the carrier foil (1) or to the covering layer (3) by means of an adhesive connection.

4. Foil conductor according to one of Claims 1 to 3, **characterized in that** the hinge part (20) is connected to the carrier foil (1) or to the covering layer (3) by means of a double-sided hybrid adhesive tape (22).

5. Foil conductor according to Claim 1 or 2, **characterized in that** the hinge part (20) is ultrasonically welded or connected by means of a mechanical holding system to the carrier foil (1) or to the covering layer (3).

6. Foil conductor according to one of Claims 1 to 5, **characterized in that** the hinge part (20) consists of plastic, in particular comprises a plastic film.

7. Foil conductor according to one of Claims 1 to 6, **characterized in that** the hinge part (20) has a total thickness (D) in the range from approximately 0.5 to 3.0 mm, in particular in the range from approximately 1.0 to 2.0 mm.

8. Foil conductor according to Claim 7, **characterized in that** in the region of the groove-like recess (23) a thickness (d) of the hinge part (20) is approximately 0.1 to 0.3 mm.

9. Foil conductor according to Claim 7 or 8, **characterized in that** a reinforcing ridge (25), in particular with a thickness (s) of approximately 0.2 to 0.6 mm, runs on a bottom (24) of the groove-like recess (23) along the fold line (21).

10. Foil conductor according to one of Claims 1 to 9, **characterized in that** a closure element is arranged on the hinge part (20), at least on one side of the fold line (21), in particular a double-sided adhesive tape portion is fastened on the surface of the hinge part (20).

11. Foil conductor according to one of Claims 1 to 10, **characterized in that** closure elements (26, 27) are arranged on the hinge part (20), on both sides and symmetrically in relation to the fold line (21), in particular mutually corresponding latching elements are fastened or formed.

12. Foil conductor according to Claim 11, **characterized in that** the latching elements are formed by at least one latching hook (26) and by a corresponding latching window (27).

13. Foil conductor according to one of Claims 1 to 12, **characterized in that** fixing elements (28, 29) engaging positively on one another are arranged or formed on the hinge part (20), on both sides and symmetrically in relation to the fold line (21).

14. Foil conductor according to Claim 13, **characterized in that** the fixing elements (28, 29) are formed by at least one pin-like fixing finger (28) and by a corresponding fixing window (29).

15. Foil conductor according to one or more of Claims 1 to 14, **characterized in that** regions of the foil circuit board (5) respectively formed as connecting leads (7) are connected to one or more other regions by means of at least one line of weakness (8) arranged in the composite comprising the carrier foil (1) and the covering layer (3).

16. Foil conductor according to Claim 15, **characterized in that** the line of weakness (8) is a perforation line and/or a scored line.

17. Foil conductor according to one or more of Claims 1 to 16, **characterized in that** a plug part (9) is fastened to a free end of a region formed as a connecting lead (7).

18. Foil conductor according to one or more of Claims 1 to 17, **characterized in that** an adhesive tape or a Velcro strip is fastened on the underside (1a) of the carrier foil (1) or on the upper side (3a) of the covering layer (3) for mounting on a component (6).

## Revendications

1. Conducteur pelliculaire tel qu'un câble à conducteur pelliculaire (7) ou une plaque à conducteur pelliculaire (5) comprenant au moins une pellicule porteuse (1) sur laquelle sont disposées des pistes conductrices électriques (2) qui sont recouvertes d'au moins une couche de revêtement (3) reliée à la pellicule porteuse (1) et aux pistes conductrices (2), ce qui forme au moins un circuit imprimé flexible, dans lequel, sur la face inférieure (1a) de la pellicule porteuse (1) ou sur la face supérieure (3a) de la couche de revêtement (3), est fixé un élément formant charnière (20) qui détermine une ligne de pliage définie (21), la ligne de pliage (21) étant déterminée par un évidement (23) en forme de rainure ménagé dans l'élément formant charnière (20), et l'élément formant charnière (20) étant constitué par une charnière film,
**caractérisé en ce que** l'évidement (23) en forme de rainure présente une section trapézoïdale lorsque l'élément formant charnière (20) se trouve dans la position étendue, le fond de l'évidement étant fixé, côté inférieur, à la face inférieure (1a) de la pellicule porteuse (1) ou sur la face supérieure (3a) de la couche de revêtement (3) de telle sorte qu'il est possible de régler des rayons de pliage et angles de pliage tels que 45 °, 60 °, 90 ° ou 180 °, qui sont définis en évitant les zones de rupture.

2. Conducteur pelliculaire selon la revendication 1,
**caractérisé en ce que** l'élément formant charnière (20) est disposé dans une région d'une plaque à conducteur pelliculaire (5) constituant une ligne de connexion (7).

3. Conducteur pelliculaire selon la revendication 1 ou 2,
**caractérisé en ce que** l'élément formant charnière (20) est relié à la pellicule porteuse (1) ou à la couche de revêtement (3) par une liaison collée.

4. Conducteur pelliculaire selon une des revendications 1 à 3,
**caractérisé en ce que** l'élément formant charnière (20) est relié à la pellicule porteuse (1) ou à la couche de revêtement (3) par une bande adhésive hybride (22) à double face.

5. Conducteur pelliculaire selon la revendication 1 ou 2,
**caractérisé en ce que** l'élément formant charnière (20) est soudé à la pellicule porteuse (1) ou la couche de revêtement (3) par ultrasons ou y est relié par un système de fixation mécanique.

6. Conducteur pelliculaire selon une des revendications 1 à 5,
**caractérisé en ce que** l'élément formant charnière (20) est fait de matière plastique, en particulier d'une pellicule de matière plastique.

7. Conducteur pelliculaire selon une des revendication 1 à 6,
**caractérisé en ce que** l'élément formant charnière (20) possède une épaisseur totale (D) comprise dans l'intervalle d'environ 0,5 à 3,0 mm, en particulier dans l'intervalle d'environ 1,0 à 2,0 mm.

8. Conducteur pelliculaire selon la revendication 7,
**caractérisé en ce que**, dans la région de l'évidement (23) en forme de rainure, une épaisseur (d) de l'élément formant charnière (20) est d'environ 0, 1 à 0,3 mm.

9. Conducteur pelliculaire selon la revendication 7 ou 8,
**caractérisé en ce qu'**une nervure de renforcement (25), possédant en particulier une épaisseur (s) d'environ 0,2 à 0,6 mm s'étend sur un fond (24) de l'évidement en forme de rainure (23) le long d'une ligne de pliage (21).

10. Conducteur pelliculaire selon une des revendications 1 à 9,
**caractérisé en ce qu'**un élément de fermeture est disposé sur l'élément formant charnière (20) au moins d'un côté de la ligne de pliage (21), en particulier un morceau de bande adhésive collante sur les deux faces est fixé sur la surface de l'élément formant charnière (20).

11. Conducteur pelliculaire selon une des revendications 1 à 10,
**caractérisé en ce que**, sur l'élément formant charnière (20) sont fixés ou formés des deux côtés et symétriquement par rapport à la ligne de pliage (21), des éléments de fermeture (26, 27), en particulier des éléments d'encliquetage qui se correspondent mutuellement.

12. Conducteur pelliculaire selon la revendication 11,
**caractérisé en ce que** les éléments d'encliquetage sont formés d'au moins un crochet d'encliquetage (26) et d'une fenêtre d'encliquetage correspondante (27).

13. Conducteur pelliculaire selon une des revendications 1 à 12,
**caractérisé en ce que** des éléments de fixation (28, 29) qui entrent en prise entre eux avec liaison par complémentarité de forme sont disposés ou formés sur l'élément formant charnière (20) des deux côtés de la ligne de pliage (21 ) et symétriquement par rapport à cette ligne.

14. Conducteur pelliculaire selon la revendication 13,
**caractérisé en ce que** les éléments de fixation (28, 29) sont formés d'au moins un doigt de fixation (28) en forme de tige et d'une fenêtre de fixation correspondante (29).

15. Conducteur pelliculaire selon une ou plusieurs des revendications 1 à 14,
**caractérisé en ce que** des régions de la plaque à conducteur pelliculaire (5) constituant des lignes de connexion (7) sont reliées à une ou plusieurs autres régions au moyen d'au moins une ligne d'affaiblissement (8) disposée dans la liaison entre la pellicule porteuse (1) et la couche de revêtement (3).

16. Conducteur pelliculaire selon la revendication 15,
**caractérisé en ce que** la ligne d'affaiblissement (8) est une ligne de perforation et/ou une ligne d'entaille.

17. Conducteur pelliculaire selon une ou plusieurs des revendications 1 à 16,
**caractérisé en ce qu'**un élément de connecteur (9) est fixé à une extrémité libre d'une région constituant une ligne de connexion (7).

18. Conducteur pelliculaire selon une ou plusieurs des revendications 1 à 17,
**caractérisé en ce qu'**une bande adhésive ou une bande auto-agrippante est fixée sur la face inférieure (1a) de la pellicule porteuse (1) et/ou sur la face supérieure (3a) de la couche de revêtement (3), pour permettre le montage sur un élément (6).
